Europäisches Patentamt

European Patent Office

Office européen des brevets

(19)

(11) Veröffentlichungsnummer: **0 135 136**

**A2**

(12) **EUROPÄISCHE PATENTANMELDUNG**

(21) Anmeldenummer: **84109633.2**

(22) Anmeldetag: **13.08.84**

(51) Int. Cl.⁴· **H 03 K 3/356**

(30) Priorität: **19.08.83 DE 3330026**

(43) Veröffentlichungstag der Anmeldung:
**27.03.85 Patentblatt 85/13**

(84) Benannte Vertragsstaaten:
**AT DE FR GB IT NL**

(71) Anmelder: **Siemens Aktiengesellschaft**
**Berlin und München Wittelsbacherplatz 2**
**D-8000 München 2(DE)**

(72) Erfinder: **Schmitt-Landsiedel, Doris, Dipl.-Ing.,**
**Dipl.-Phys.**
**Metzstrasse 25**
**D-8000 München 80(DE)**

(72) Erfinder: **Dorda, Gerhard, Dr.**
**Triester Strasse 11**
**D-8000 München 80(DE)**

(54) **Integrierte RS-Flipflop-Schaltung.**

(57) Integrierte RS-Flipflop-Schaltung mit zwei kreuzgekoppelten Invertern, die jeweils aus einem Feldeffekttransistor (T1, T2) und einem in Serie geschalteten Widerstandselement (R1, R2) bestehen. Jeder Feldeffekttransistor ist mit einem zusätzlichen Schaltelement (T3, T4) verbunden, dessen Steuereingang den R- bzw. S-Eingang darstellt. Angestrebt wird eine Realisierung der Flipflopschaltung auf einer möglichst kleinen Halbleiterfläche. Das wird erreicht durch eine Ausbildung der zusätzlichen Schaltelemente (T3, T4) als Heiße-Elektronen-Transistoren, von denen jeder mit einem der Feldeffekttransistoren (T1, T2) zu einem gemeinsamen Bauelement (5, 6) zusammengefaßt wird, das zwei Transistorfunktionen übernimmt, aber nur die Fläche eines Feldeffekttransistors benötigt. Der Anwendungsbereich umfaßt hochintegrierte Schaltungskreise.

FIG 1

EP 0 135 136 A2

SIEMENS AKTIENGESELLSCHAFT          Unser Zeichen

Berlin und München                  VPA 83 P 1 6 1 1 E

Integrierte RS-Flipflop-Schaltung

Die Erfindung bezieht sich auf eine integrierte RS-Flipflop-Schaltung nach dem Oberbegriff des Patentanspruchs 1 und auf deren Verwendung als Halbleiterspeicherzelle.

Eine Flipflop-Schaltung dieser Art ist aus dem Buch "Mikroelektronische Schaltkreise" von A. Möschwitzer und G. Jorke, VEB Verlag Technik, Berlin, 1979, S. 118, Bild 2.37c, bekannt. Dabei sind die Schaltelemente ebenfalls als Feldeffekttransistoren realisiert, die den Feldeffekttransistoren der kreuzgekoppelten Inverter mit ihren Source-Drain-Strecken parallel geschaltet sind und mit ihren Gateanschlüssen den R- bzw. S-Eingang darstellen.

Der Erfindung liegt die Aufgabe zugrunde, eine integrierte RS-Flipflop-Schaltung anzugeben, die auf einer wesentlich kleineren Halbleiterfläche realisiert werden kann, als vergleichbare herkömmliche Schaltungen. Erfindungsgemäß wird dies durch eine Ausbildung nach dem kennzeichnenden Teil des Patentanspruchs 1 erreicht.

Der mit der Erfindung erzielbare Vorteil besteht insbesondere darin, daß der die Schaltfunktion übernehmende Feldeffekttransistor jedes Inverters zusammen mit dem ihm zugeordneten Schaltelement aus einem einzigen Halbleiterbauelement besteht, das zwei Transistorfunktionen übernimmt und zur Realisierung lediglich die Halbleiterfläche eines einzigen MIS-Feldeffekttransistors benötigt. Die Schaltgeschwindigkeit am R- und S-Eingang ist außerdem gegenüber herkömmmlichen Schaltungen stark erhöht.

St 1 Sti/9.8.1983

Die Ansprüche 2 bis 10 sind auf bevorzugte Ausgestaltungen und Weiterbildungen der Erfindung gerichtet, während der Anspruch 11 die Verwendung der RS-Flipflop-Schaltung als Speicherzelle betrifft.

Nachfolgend wird die Erfindung anhand der Zeichnungen näher erläutert. Dabei zeigt:

Fig. 1 ein erfindungsgemäß ausgebildetes RS-Flipflop,

Fig. 2 den Querschnitt eines in Fig. 1 schematisch dargestellten Bauelements, das einen MIS-Feldeffekttransistor und einen Heiße-Elektronen-Transistor aufweist,

Fig. 3 ein Bandstrukturschema zur Erläuterung von Fig. 2 und

Fig. 4 ein erfindungsgemäßes RS-Flipflop, das als eine statische Speicherzelle verwendet wird.

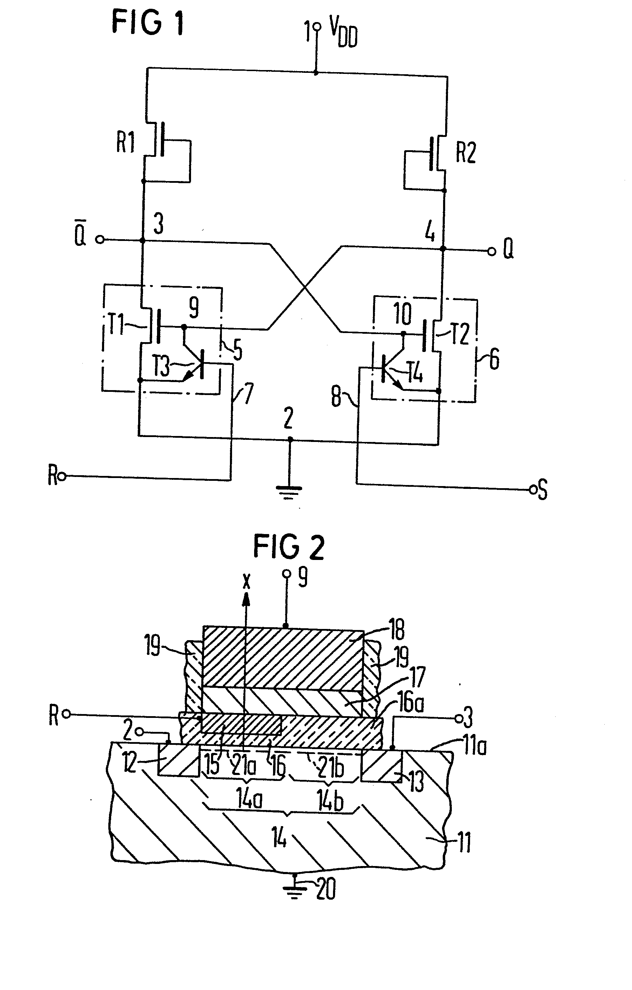

In Fig. 1 sind zwei kreuzgekoppelte Inverter dargestellt, die eine Flipflop-Schaltung bilden. Der erste Inverter besteht aus der Serienschaltung eines Feldeffekttransistors T1 und eines Widerstandselementes R1, wobei die endseitigen Anschlüsse 1 und 2 der Serienschaltung jeweils mit der Versorgungsspannung $V_{DD}$ und dem Bezugspotential beschaltet sind. Der zweite Inverter, der einen Feldeffekttransistor T2 und ein Widerstandselement R2 umfaßt, liegt ebenfalls an den Anschlüssen 1, 2. Zwischen T1 und R1 befindet sich ein Schaltungsknoten 3, der mit dem Gate von T2 verbunden ist, zwischen T2 und R2 ein Schaltungsknoten 4, der an das Gate von T1 geführt ist. Die Widerstandselemente R1 und R2, die in Fig. 1 als Feldeffekttransistoren des Verarmungstyps dargestellt sind, deren Gateelektroden mit den Sourceanschlüssen verbunden sind, können auch in anderer Weise realisiert werden, so z.B. als Feldeffekttransistoren des Anreicherungstyps, deren Gateelektroden mit den Drainanschlüssen verbunden sind, als streifenförmige Strukturen aus widerstandsbehaftetem Material oder dgl.. Die Schaltungsknoten 4 und 3 stellen gleichzeitig den Ausgang Q und den inversen Ausgang $\overline{Q}$ der Flipflop-Schaltung dar.

Mit T3 ist ein Heiße-Elektronen-Transistor des Tunnelemissionstyps bezeichnet, der mit dem Transistor T1 zu einem Bauelement 5 zusammengefaßt ist. Ein weiterer Heiße-Elektronen-Transistor T4 ist mit dem Feldeffekttransistor T2 zu einem Bauelement 6 zusammengefaßt. Dabei sind die Basisanschlüsse der Transistoren T3 und T4 mit Anschlußleitungen 7 und 8 versehen, die mit dem R- bzw. S-Eingang der Schaltung verbunden sind. Der Kollektoranschluß 9 von T3 ist mit dem Schaltungsknoten 4 beschaltet, der Kollektoranschluß 10 von T4 mit dem Schaltungsknoten 3. Heiße-Elektronen-Transistoren sind z.B. aus Solid-State Electronics, Bd. 24, 1981, S. 343 - 366, insbesondere Fig. 1, bekannt.

Fig. 2 zeigt das in Fig. 1 mit 5 bezeichnete Halbleiter-Bauelement im Querschnitt. Es ist auf einem Körper 11 aus dotiertem Halbleitermaterial, z.B. p-dotiertem Silizium mit einer Störstellenkonzentration von etwa $10^{15}/cm^3$, angeordnet, in den zwei von einer Grenzfläche 11a ausgehende, z.B. $n^+$-dotierte Gebiete 12 und 13 eingefügt sind. Diese stellen das Sourcegebiet und das Draingebiet des Feldeffekttransistors T1 dar, dessen Gateelektrode aus zwei Teilen besteht. Der erste Teil wird von einer metallischen bzw. metallisch leitenden Schicht 15 gebildet, die den an das Gebiet 12 grenzenden Teil 14a des zwischen 12 und 13 liegenden Kanalbereichs 14 überdeckt. Zwischen der Schicht 15 und der Grenzfläche 11a liegt dabei eine sehr dünne Isolatorschicht 16.

Die Dicke der z.B. aus $SiO_2$ oder $Si_3N_4$ bestehenden Isolatorschicht 16 beträgt zweckmäßigerweise etwa 2 bis 5 nm. Die Schicht 15 besteht mit Vorteil aus einem hochschmelzenden Metall, z.B. aus Ta, Ti oder Mo oder W, oder aus dem Silizid eines dieser Metalle, d.h. aus $TaSi_2$, $TiSi_2$, $MoSi_2$ oder $WSi_2$, und kann eine Dicke von etwa 10 nm aufweisen. Oberhalb der Schicht 15 befindet sich eine polykristalline Siliziumschicht 17 mit einer Dicke von etwa 10 bis 100 nm und vorzugsweise mit einer p-Dotierung, die etwa durch eine Dotierungskonzentration von $10^{14}$ bis $10^{15}/cm^3$ gegeben ist, wobei als Dotierstoff Bor herangezogen werden kann. Auf der Schicht 17 befindet sich eine metallische bzw. metallisch leitende Schicht 18, deren Dicke beliebig gewählt sein kann, zweckmäßigerweise jedoch größer ist als die Schichtdicke von 17. Die Schicht 18 besteht dabei mit Vorteil aus einem der Metalle oder Silizide, die bereits im Zusammenhang mit der Schicht 15 genannt worden sind. Die Schichten 17 und 18 überdecken den gesamten Kanalbereich 14, wobei derjenige Teil von 18, der die Schicht 15 lateral überragt, den zweiten Teil der Gateelektrode bildet und als solcher den Teil 14b des Kanalbereichs 14 überdeckt. Eine die Oberfläche 11a außerhalb der Teile 12 bis 14 abdeckende elektrisch isolierende Schicht (Feldoxidschicht) weist an die Schichten 17 und 18 lateral angrenzende Teile 19 auf.

Das Sourcegebiet 12 ist mit dem Anschluß 2 verbunden, das Draingebiet 13 mit dem Schaltungsknoten 3. Der Halbleiterkörper 11 ist bei 20 mit dem Bezugspotential beschaltet. Ferner ist die Basisschicht 15 mit dem Eingang R verbunden, während die Schicht 18 mit dem Kollektoranschluß 9 versehen ist.

Erhält der aus der Schicht 15 bestehende Teil der Gateelektrode des Feldeffekttransistors T1 über den Eingang R eine Spannung zugeführt, die oberhalb eines als erste Einsatzspannung bezeichneten Wertes liegt, so bildet sich im Halbleiterkörper 11 unterhalb von 15 eine von der Grenzfläche 11a ausgehende Verarmungszone aus, wobei sich innerhalb dieser Verarmungszone unmittelbar an der Grenzfläche 11a eine Inversionsschicht 21a aufbaut, die einen n-leitenden Kanal unterhalb von 15 bildet. Die Inversionsschicht 21a stellt die Emitterschicht eines Heiße-Elektronen-Transistors (HET) des Tunnelemisionstyps dar, der zusätzlich die Schichten 15, 16, 17 und 18 aufweist. Dabei bildet die Schicht 15 eine metallische bzw. metallisch leitende Basisschicht des HET, wobei sich die Isolatorschicht 16 zwischen der Schicht 15 und der Emitterschicht 21a befindet, während die polykristalline Siliziumschicht 17 zusammen mit der metallischen bzw. metallisch leitenden Schicht 18 die Kollektorschicht des HET darstellt. Über den Anschluß 9 wird der Schicht 18 eine Kollektorspannung zugeführt, die in Fig. 1 aus der Spannung am Schaltungsknoten 4 besteht. Übersteigt diese Spannung eine zweite Einsatzspannung, die dem Teil 14b des Kanalbereichs 14 zugeordnet ist, so bildet sich unterhalb von dem die Schicht 15 lateral überragenden Teil der Schicht 18 eine Inversionsschicht 21b aus, die zusammen mit der Inversionsschicht 21a einen n-leitenden Kanal zwischen den Gebieten 12 und 13 bildet. Daß sich ein Teil 16a der Isolatorschicht 16, der mit z.B. 15 nm wesentlich dicker ist als die übrigen Teile dieser Schicht, zwischen dem zweiten von der Schicht 18 gebildeten Teil der Gateelektrode und dem Teil 14b des Kanalbereichs 14 befindet, ist mitbestimmend dafür, daß die zweite Einsatzspannung höher ist als die erste. Die genannte Verarmungszone und die Inversionsschicht 21a unterhalb von 15 werden auch dann aufgebaut, wenn bei spannungslosem Anschluß R am Anschluß 9 eine die zweite Einsatzspannung übersteigende Spannung liegt.

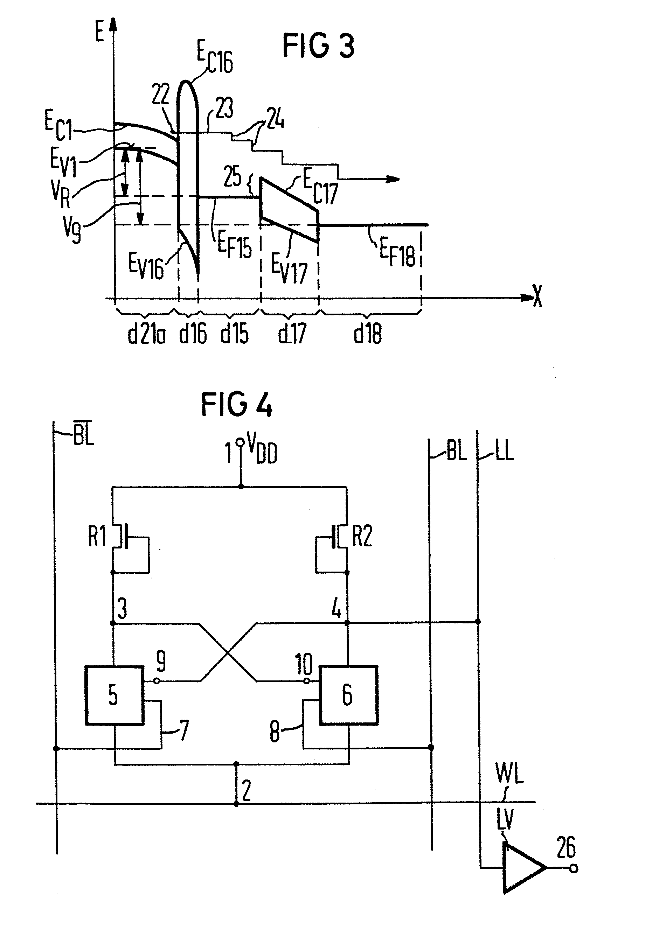

Die Funktion des HET sei nachfolgend anhand des in Fig.3 dargestellten energetischen Bandstrukturschemas erläutert. Dieses zeigt in Richtung der vertikalen Achse aufgetragene Energiezustände E, die in Abhängigkeit von verschiedenen Entfernungen x von der Inversionsschicht bzw. Emitterschicht 21a auftreten. Diese Entfernungen sind auf der Achse x aufgetragen, die in Fig. 2 die Schichten des HET in vertikaler Richtung, d.h. senkrecht zur Grenzfläche 11a, durchdringt. Den Schichten 21a, 16, 15, 17 und 18 sind aufeinanderfolgende Abschnitte der x-Achse zugeordnet, wobei aus Gründen einer deutlichen Darstellung die Längen d21a, d16, d15, d17 und d18 dieser Abschnitte von den tatsächlichen Schichtdicken D21a, D16, D15, D17 und D18 der Schichten 21a, 16, 15, 17 und 18 abweichen. So ist z.B. der Abschnitt d16 gegenüber den Abschnitten d15, d17, d18 und d21a stark gedehnt. In dem der Inversionsschicht 21a zugeordneten Abschnitt d21a ist die obere Grenze des Valenzbandes des Halbleitermaterials von 11 mit $E_{v1}$ bezeichnet, während $E_{c1}$ das Energieniveau der Elektronen innerhalb der Inversionsschicht 21a darstellt. Im Abschnitt d16 stellt die obere Linie $E_{c16}$ die untere Begrenzung des Leitungsbandes der Isolatorschicht 16 dar, während die untere Linie $E_{v16}$ die obere Grenze des Valenzbandes bedeutet. In den Abschnitten d15 und d18 sind die jeweiligen Fermi-Niveaus $E_{F15}$ und $E_{F18}$ eingetragen, während im Abschnitt d17 die untere Grenze des Leitungsbandes der Schicht 17 durch $E_{c17}$ und die obere Grenze des Valenzbandes durch $E_{v17}$ dargestellt werden.

Bei einer hinreichend kleinen Dicke D16 der Isolatorschicht 16 gelangen Elektronen aus der Inversionsschicht 21a, die in Fig. 3 gemäß ihrem Energieniveau z.B. durch den Punkt 22 gekennzeichnet sind, infolge des Tunneleffekts durch die Isolatorschicht 16 in die Basisschicht 15, wie durch die horizontale Gerade 23 angedeutet wird.

Durch Streuung an Fehlstellen und am Kristallgitter der Schicht 15 verlieren sie an Energie, was durch den treppenförmigen Verlauf 24 ausgedrückt wird. Ist die Energie dieser Elektronen danach noch so groß, daß sie die Energieschwelle 25 an der Grenzfläche zwischen den Schichten 15 und 17 überwinden können, so gelangen sie in die aus den Schichten 17 und 18 bestehende Kollektorschicht des HET. Die Größen der über die Anschlüsse R und 9 gegenüber dem Bezugspotential angelegten Spannungen sind in Fig. 3 mit $V_R$ und $V_9$ bezeichnet.

Das Halbleiterbauelement 6 ist analog zu 5 aufgebaut und entsprechend Fig. 1 mit den Anschlüssen 2, 4, 10 und S versehen.

Befindet sich das RS-Flipflop nach Fig. 1 in gesetztem Schaltzustand (T1 leitet, T2 sperrt), so ist am Ausgang Q eine etwa der Versorgungsspannung $V_{DD}$ entsprechende Spannung abgreifbar, die einer logischen "1" entspricht, während der Ausgang $\overline{Q}$ etwa auf Bezugspotential liegt, was einer logischen "0" entspricht. Dabei liegt die am Ausgang Q bzw. am Schaltungsknoten 4 abgreifbare Spannung auch am Kollektoranschluß 9 von 5. Diese Spannung ist so groß, daß beim Transistor T1 sowohl die erste Einsatzspannung von 14a als auch die zweite Einsatzspannung von 14b überschritten werden, und die Inversionsschichten 21a und 21b einen leitenden Kanal zwischen den Gebieten 12 und 13 bilden. Andererseits ist die am Schaltungsknoten 3 auftretende Spannung in diesem Schaltzustand so klein, daß die beiden Einsatzspannungen des Transistors T2 unterschritten werden, so daß T2 sperrt. Wird nun dem Eingang R ein Spannungsimpuls zugeführt, der die Basisschicht 15 gegenüber der Inversionsschicht 21a des Transistors T1 positiv vorspannt, so gelangen Elektronen aus 21a infolge

des Tunneleffekts durch die Isolatorschicht 16 in die Basisschicht 15 und weiter zur Kollektorschicht 18. Hierdurch fließt ein Strom im Schaltungszweig 1, R2, 4, 9, T3 und 2, der an R2 einen Spannungsabfall hervorruft. Um diesen Spannungsabfall wird die Spannung an 4 bzw. am Anschluß 9 von 5 abgesenkt. Dadurch wird die zweite Einsatzspannung von T1 unterschritten, so daß T1 sperrt. Als Folge hiervon steigt die Spannung am Schaltungsknoten 3 fast auf den Wert der Versorgungsspannung $V_{DD}$, so daß T2 über den Anschluß 10 eine Gatespannung von solcher Größe zugeführt wird, daß die Inversionsschichten 21a und 21b von T2 aufgebaut werden und T2 in den stromführenden Zustand gelangt. Damit befindet sich aber die Flipflop-Schaltung im rückgesetzten Zustand. Der Emitter-Basis-Kreis des HET T3 wird nach dem Abschalten des Spannungsimpulses an R und dem damit verbundenen Unterschreiten der ersten Einsatzspannung stromlos.

Wird der Eingang S im gesetzten Zustand des Flipflops mit einem Impuls beaufschlagt, so beeinflußt das den gesperrten Zustand des HET T4 nicht, weil ihm wegen des leitenden Transistors T1 über den Anschluß 10 keine ausreichende Kollektorspannung zugeführt wird.

Im rückgesetzten Zustand des Flipflops (T2 leitet, T1 sperrt) laufen bei Zuführung eines Impulses an den Eingang S analoge Schaltvorgänge im Stromzweig 1, R1, 3, 10, T4 und 2 ab, durch die die Spannung bei 3 herabgesetzt wird, der Transistor T2 gesperrt wird, der Transistor T1 stromführend wird und das Flipflop somit in den gesetzten Zustand gelangt.

Die Herstellung des Halbleiterbauelements nach Fig. 2 entspricht zunächst der üblichen Herstellung eines Feldeffekttransistors. Nachdem eine den Halbleiterkörper 11 ganzflächig bedeckende Feldoxidschicht 19 oberhalb des Kanalbereiches 14 und der Gebiete 12 und 13 weggeätzt und in dem weggeätzten Bereich eine Isolatorschicht mit einer Dicke von z.B. 15 nm aufgewachsen wurde, was etwa der Dicke des Teils 16a in Fig. 2 entspricht, wird eine Zwischenmaske auf der Isolatorschicht angebracht, die mit ihrer Öffnung lediglich den Bereich der metallisch leitenden Schicht 15 freiläßt. In diesem Bereich wird die Isolatorschicht, z.B. durch ein Ätzmittel auf Fluor-Wasserstoff-Basis, auf eine Dicke von etwa 2 bis 5 nm abgeätzt, was in Fig. 2 durch die reduzierte Dicke der Schicht 16 oberhalb von 14a angedeutet ist. Unter Verwendung derselben Zwischenmaske wird dann die Schicht 15 aufgebracht. Nach dem Entfernen der Zwischenmaske wird eine weitere Maske angebracht, die eine die lateralen Abmessungen der Schichten 17 und 18 definierende Öffnung enthält. Unter Anwendung dieser Maske werden dann die Schichten 17 und 18 nacheinander aufgebracht. Dabei wird die Schicht 17 mit einer p-Dotierung versehen, deren Konzentration $10^{14}$ bis $10^{15}/$ $cm^3$ beträgt, bevor die Schicht 18 aufgebracht wird. Nach dem Entfernen der Maske erfolgt eine Implantation eines Dotierstoffes zur Erzeugung der Gebiete 12 und 13, wobei die Schichten 15, 17 und 18 sowie die Feldoxidschicht als Teile einer Dotierungsmaske dienen (Selbstjustierung). Nach dem Anbringen von Anschlußleitungen, die zu den Schaltungspunkten 2 und 3 führen und die die Teile 12 und 13 durch Kontaktlöcher in der Isolatorschicht 16 kontaktieren, werden oberhalb der Gebiete 12 und 13 die vorher weggeätzten Teile der Feldoxidschicht wieder so weit aufgebaut, daß die Feldoxidschicht an die lateralen Begrenzungsflächen der Schichten 15, 17 und 18 heranreicht, wie das in Fig. 2 durch die Teile 9 angedeutet ist. Danach wird eine Anschlußleitung verlegt, die zum Anschluß 9 führt.

Nach einer anderen bevorzugten Ausführungsform der Erfindung ist das Halbleiterbauelement 5 bzw. 6 auf einem Körper 11 aus einer p-dotierten III-V-Halbleiterverbindung, z.B. GaAs mit einer Dotierungskonzentration von z.B. $10^{16}/cm^3$, aufgebaut, wobei die Isolatorschicht 16 zweckmäßigerweise aus AlGaAs besteht. An die Stelle der polykristallinen Siliziumschicht 17 tritt hier eine Schicht aus p-dotiertem GaAs mit Be als Dotierstoff, während die Schicht 15 vorzugsweise aus einer hochdotierten n-leitenden III-V-Halbleiterverbindung, z.B. GaAs mit Si als Dotierstoff, gebildet wird, die sich bei einer Dotierungskonzentration von etwa $10^{18}/cm^3$ hinsichtlich ihrer elektrischen Leitfähigkeit ähnlich wie ein Metall verhält. Die Schicht 18 besteht auch hierbei mit Vorteil aus dem gleichen Material wie die Schicht 15.

Bei einer weiteren Ausführungsform der Erfindung ist das Halbleiter-Bauelement 5 bzw. 6 so ausgebildet, daß an die Stelle der bisher beschriebenen Schicht 17 eine zweite Isolatorschicht tritt, die in ihrem Aufbau und in ihrer Dicke vorzugsweise der Isolatorschicht 16 entspricht. Für den Fall, daß ein Halbleiterkörper 11 aus p-dotiertem Silizium vorgesehen ist, besteht die zweite Isolatorschicht aus $SiO_2$ oder $Si_3N_4$, bei einem Halbleiterkörper aus GaAs aus AlGaAs. Ihre Dicke beträgt zweckmäßigerweise etwa 2 bis 5 nm.

Fig. 4 zeigt die Verwendung der erfindungsgemäßen Flipflop-Schaltung als statische Speicherzelle. Dabei ist die in Fig. 1 dargestellte Schaltung insoweit ergänzt, als der Anschluß 2 mit einer Wortleitung WL verbunden ist, die zur Adressierung der Speicherzelle dient, während die Anschlußleitungen 8 und 7 jeweils mit einer Bitleitung BL bzw. mit einer zweiten Bitleitung $\overline{BL}$ beschaltet sind, die ein jeweils inverses Signal zu dem auf BL führt. Der Schaltungsknoten 4 (oder der Schaltungsknoten 3) ist schließlich mit einer Leseleitung LL verbunden. Üblicherweise sind eine Vielzahl von solchen Speicherzellen in mehreren Zeilen und Spalten neben- und übereinander angeordnet, wobei die in einer Zeile liegenden Speicherzellen an derselben Wortleitung WL liegen, während sämtliche in einer Spalte befindlichen Speicherzellen mit denselben Bitleitungen und derselben Leseleitung beschaltet sind. Die Leseleitung LL ist an den Eingang eines Leseverstärker LV geführt, an dessen Ausgang 26 das jeweils ausgelesene Speichersignal abgreifbar ist.

Die Wortleitung WL liegt im Ruhezustand auf einem Potential $V_x$, das einer logischen "1" auf der Leitung BL oder $\overline{BL}$ entspricht oder diese übersteigt oder um weniger als den Wert der ersten Einsatzspannung von T1 oder T2 kleiner ist als eine solche "1". Hierdurch wird erreicht, daß die Transistoren T3 und T4 beim Auftreten eines "1"-Signals auf BL oder $\overline{BL}$, das in eine andere, an denselben Bitleitungen liegende, über ihre Wortleitung selektierte Speicherzelle eingeschrieben werden soll, nicht beeinflußt werden. Erst wenn das Potential auf WL etwa auf das Bezugspotential abgesenkt wird, ist eine an ihr liegende Speicherzelle selektiert und damit adressierbar. Befindet sich diese Zelle im rückgesetzten Zustand (T2 leitet, T1 sperrt) so wird sie durch eine "1" auf BL in den gesetzten Zustand umgeschaltet, wodurch die "1" eingeschrieben wird. Eine logische "0" wird durch Zuführung eines entsprechenden Signals über die Bitleitung $\overline{BL}$ eingeschrieben. Nach dem Einschreiben wird das Potential auf der Wortleitung WL wieder auf $V_x$ angehoben, so daß das gespeicherte Signal nicht unabsichtlich gelöscht bzw. überschrieben werden kann.

Das Lesen des jeweils gespeicherten Signals erfolgt dann nach dem Absenken des Potentials von WL etwa auf Bezugspotential über die Leitung LL, wobei der Eingang des Leseverstärkers LV beim Auslesen einer "1" mit einem Signal belegt wird, beim Auslesen einer "O" dagegen nicht.

Die "1"-Signale auf den Bitleitungen BL und $\overline{BL}$ müssen um den Betrag der Basis-Emitterspannung $V_R$ (Fig. 3) größer sein als das Potential, auf das die Wortleitung WL beim Selektieren der Zelle abgesenkt wird.

11 Patentansprüche
4 Figuren

**0135136**

<u>Patentansprüche</u>

1. Integrierte RS-Flipflop-Schaltung mit zwei kreuzgekoppelten Invertern, die jeweils aus einem Feldeffekttransistor (T1, T2) und einem über einen Schaltungsknoten (3, 4) zu diesem in Serie geschalteten Widerstandselement (R1, R2) bestehen, wobei der Schaltungsknoten (3, 4) jedes Inverters mit der Gateelektrode des zum anderen Inverter gehörenden Feldeffekttransistors (T2, T1) beschaltet ist, und wobei jeder Feldeffekttransistor (T1, T2) mit einem Schaltelement verbunden ist, dessen Steuereingang den R- bzw. S-Eingang bildet, d a d u r c h   g e k e n n z e i c h n e t , daß die Schaltelemente jeweils aus einem Heiße-Elektronen-Transistor (HET) des Tunnelemissionstyps (T3, T4) bestehen, der eine Emitterschicht, eine Isolatorschicht, eine Basisschicht und eine Kollektorschicht aufweist, daß jeder Heiße-Elektronen-Transistor (T3) mit dem ihm zugeordneten Feldeffekttransistor (T1) derart zusammengefaßt ist, daß die Emitterschicht aus einer Inversionsschicht (21a1) im Kanalbereich (14) des Feldeffekttransistors (T1) besteht, daß die Basisschicht (15) einen ersten Teil der Gateelektrode darstellt, daß die Isolatorschicht (16) zwischen der Basisschicht und einem ersten Teil des Kanalbereichs angeordnet ist, und daß die Kollektorschicht mit einem die Basisschicht (15) lateral überragenden Teil (18) den restlichen Teil der Gateelektrode darstellt, der den restlichen Teil des Kanalbereichs (14) überdeckt, wobei die Kollektorschicht einen Anschluß (9) aufweist, der mit dem Schaltungsknoten (4) des jeweils anderen Inverters beschaltet ist, und wobei die Basisschichten der Heiße-Elektronen-Transistoren (T3, T4) jeweils mit dem R- und S- Eingang verbunden sind.

2. Integrierte RS-Flipflop-Schaltung nach Anspruch 1,
d a d u r c h   g.e k e n n z e i c h n e t , daß die
Widerstandselemente (R1, R2) als Feldeffekttransistoren
des Verarmungstyps realisiert sind.

3. Integrierte RS-Flipflop-Schaltung nach Anspruch 1
oder 2, d a d u r c h   g e k e n n z e i c h n e t ,
daß die Basisschicht (15) aus einem Metall besteht, das
insbesondere einer Gruppe von hochschmelzenden Metallen
angehört, in der Ta, Ti, Mo und W enthalten sind, oder
aus einem Silizid eines solchen Metalls.

4. Integrierte RS-Flipflop-Schaltung nach Anspruch 1
oder 2, d a d u r c h   g e k e n n z e i c h n e t ,
daß die Basisschicht (15) aus einer hochdotierten
III-V-Halbleiterverbindung, wie z.B. GaAs, besteht, die
mit einer n-Dotierung versehen ist.

5. Integrierte RS-Flipflop-Schaltung nach Anspruch 1
oder 2, d a d u r c h   g e k e n n z e i c h n e t ,
daß die Kollektorschicht aus einer metallischen oder
metallisch leitenden Schicht (18) und einer zwischen
dieser und der Basisschicht (15) befindlichen, polykristallinen, vorzugsweise mit einer p-Dotierung versehenen, Siliziumschicht (17) besteht.

6. Integrierte RS-Flipflop-Schaltung nach Anspruch 1
oder 2, d a d u r c h   g e k e n n z e i c h n e t ,
daß die Kollektorschicht aus einer metallischen oder
metallisch leitenden Schicht (18) und einer zwischen
dieser und der Basisschicht (15) befindlichen Schicht
(17) aus einer III-V-Halbleiterverbindung, wie z.B.
GaAs, besteht, die vorzugsweise mit einer p-Dotierung
versehen ist.

7. Integrierte RS-Flipflop-Schaltung nach Anspruch 1 oder 2, d a d u r c h   g e k e n n z e i c h n e t , daß die Kollektorschaltung aus einer metallischen oder metallisch leitenden Schicht (18) und einer zwischen dieser und der Basisschicht (15) befindlichen, zweiten Isolierschicht (17) besteht.

8. Integrierte RS-Flipflop-Schaltung nach einem der Ansprüche 5 bis 7, d a d u r c h   g e k e n n - z e i c h n e t , daß die einen Teil der Kollektorschicht darstellende metallische oder metallisch leitende Schicht (18) aus einem Metall besteht, das insbesondere einer Gruppe von hochschmelzenden Metallen angehört, in der Ta, Ti, Mo und W enthalten sind, oder aus einem Silizid eines solchen Metalls.

9. Integrierte RS-Flipflop-Schaltung nach einem der Ansprüche 5 bis 7, d a d u r c h   g e k e n n z e i c h - n e t , daß die einen Teil der Kollektorschicht darstellende metallische oder metallisch leitende Schicht (18) aus einer hochdotierten III-V-Halbleiterverbindung, wie z.B. GaAs, besteht, die mit einer n-Dotierung versehen ist.

10. Integrierte RS-Flipflop-Schaltung nach einem der Ansprüche 1 bis 7, d a d u r c h   g e k e n n z e i c h - n e t , daß die Dicke der zwischen der Basisschicht (15) und dem ersten Teil des Kanalbereichs (14) befindlichen Isolatorschicht (16) und gegebenenfalls die Dicke der zweiten Isolatorschicht (17) etwa 2 bis 5 nm beträgt.

11. Verwendung der integrierten RS-Flipflop-Schaltung nach einem der Ansprüche 1 bis 10 als statische Speicherzelle, d a d u r c h   g e k e n n z e i c h n e t , daß beide Feldeffekttransistoren (T1, T2) mit einer Wortleitung (WL) verbunden sind, daß die Basisschichten (15) der Heiße-Elektronen-Transistoren (T3, T4) jeweils mit einer Bitleitung (BL) und der zu dieser inversen Bitleitung ($\overline{BL}$) beschaltet werden, die zur Zuführung von einzuschreibenden Signalen dienen, und daß einer der Schaltungsknoten (3, 4) mit einer Leseleitung (LL) verbunden ist, die an den Eingang eines Leseverstärkers (LV) geführt ist.

FIG 1

FIG 2

## FIG 3

## FIG 4